# EUROPEAN PATENT APPLICATION

(11) **EP 4 709 104 A2**
(43) Date of publication of application: **11.03.2026**
(21) Application number: 26154410.0
(22) Date of filing: 28.03.2025
(51) Int. Cl.: H10F 77/30

(54) **SOLAR CELL, TANDEM SOLAR CELL AND PHOTOVOLTAIC MODULE**

(30) Priority: 01.04.2024 CN 202410390636
(62) Divisional of application: 25167119.4
(71) Applicant: Zhejiang Jinko Solar Co., Ltd., Haining, Zhejiang 314416 (CN); Jinko Solar (Haining) Co., Ltd., Haining, Zhejiang 314415 (CN)
(72) Inventor: JIN, Jingsheng, Haining, 314415 (CN); LIAO, Guangming, Haining, 314415 (CN); CUI, Wei, Haining, 314415 (CN)
(74) Representative: Müller Schupfner & Partner Patent- und Rechtsanwaltspartnerschaft mbB (Muc)

(57) **Abstract**

The present application relates to a solar cell, a tandem solar cell, and a photovoltaic module. The solar cell includes a solar cell body (10), a first passivation layer (30), and a field passivation layer (40). The solar cell body includes a substrate (1) and an emitter (2) formed on one side of the substrate along a thickness direction of the solar cell, and the solar cell body includes at least one cutting surface (9) parallel to the thickness direction. The first passivation layer (30) is disposed on the cutting surface. The field passivation layer (40) is disposed on one side of the first passivation layer facing away from the substrate. With the mutual cooperation of the first passivation layer (30) and the field passivation layer (40), the solar cell of the present application can achieve better passivation of the regions of the substrate (1) and the emitter (2) of the solar cell body which have been exposed on the cutting surface simultaneously, to enhance the effect of repairing the cutting damage of the solar cell, and thus to enhance the efficiency of the solar cell and to enhance module power.

## Description

### TECHNICAL FIELD

The present application relates to the technical field of photovoltaic cells, and in particular, to a solar cell, a tandem solar cell and a photovoltaic module.

### BACKGROUND

Nowadays, many module technologies have emerged to improve the energy density of a photovoltaic module. Among these technologies, module half-cut technology, stacked welding technology, and shingling technology are representative technologies. These technologies are characterized by cutting a whole solar cell wafer into one-half, one-third, or even smaller size of cut cell pieces, to fill as many cut cell pieces as possible in a module, increasing effective power generation area, and at the same time, due to the reduction of the current in the cut cell pieces, causing a decrease in the loss of power and comprehensively improving the power of the module. In industrial applications, the way of dividing a solar cell wafer generally includes laser scribe and mechanical cleave, thermal laser low-damage cleave, etc., however, dividing the solar cell wafer will cause some damage to the cutting surfaces of the cutting cells, which will easily lead to a great recombination rate on the surfaces of the silicon wafer sections (side cutting surfaces) of the cutting cells, and reduce the efficiency of the cutting cells.

### SUMMARY

In view of this, the present application provides a solar cell, a tandem solar cell and a photovoltaic module, to facilitate solving the problem in the related art that dividing the solar cell wafer will cause some damage to the cutting surfaces of the cutting cells, which will easily lead to a large recombination rate on the surfaces of the silicon wafer sections (side cutting surfaces) of the cutting cells, and reduce the efficiency of the cutting cells.

A first aspect of the present application provides a solar cell including a solar cell body, a first passivation layer, and a field passivation layer. The solar cell body includes a substrate and an emitter formed on one side of the substrate along a thickness direction of the solar cell, and the solar cell body includes at least one cutting surface parallel to the thickness direction. The first passivation layer is disposed on the cutting surface. The field passivation layer is disposed on one side of the first passivation layer facing away from the first passivation layer. The field passivation layer and the emitter have doping elements of different conductivity types.
a doping concentration of the field passivation layer is greater than a doping concentration of the substrate.
the field passivation layer is one or more of a doped polycrystalline silicon layer, a doped amorphous silicon layer or a doped microcrystalline silicon layer.

In one possible design, along a first direction of the solar cell, a thickness d1 of the field passivation layer satisfies: 10 nm ≤ d1 ≤ 100 nm; the first direction is perpendicular to the thickness direction.

In one possible design, the first passivation layer is one or more of an aluminum oxide layer, a silicon oxide layer, a silicon nitride layer or a silicon oxynitride layer.

In one possible design, the first passivation layer includes at least an alumina layer.

In one possible design, along a first direction of the solar cell, a thickness d2 of the first passivation layer satisfies: 1 nm ≤ d2 ≤ 4 nm.

In one possible design, the solar cell body further includes a second passivation layer and a first electrode; where the second passivation layer is disposed on one side of the emitter away from the substrate; and the first electrode passes through the second passivation layer to be electrically connected to the emitter.

In one possible design, the solar cell body further includes a tunnel oxide layer, a doped conductive layer, a third passivation layer, and a second electrode along the thickness direction of the solar cell; where the tunnel oxide layer is disposed on one side of the substrate away from the emitter; the doped conductive layer is disposed on one side of the tunnel oxide layer away from the substrate; the third passivation layer is disposed on one side of the doped conductive layer away from the tunnel oxide layer; and the second electrode passes through the third passivation layer to be electrically connected to the doped conductive layer.

A second aspect of the present application provides a tandem solar cell including a bottom solar cell, a top solar cell, and an intermediate connecting layer. The bottom solar cell is a solar cell as described in any one of the above embodiments. The top solar cell is one of a perovskite solar cell, a donor-acceptor solar cell, a cadmium telluride solar cell, a copper indium gallium selenide solar cell, or a gallium arsenide solar cell. The intermediate connecting layer is connected between the bottom solar cell and the top solar cell.

A third aspect of the present application provides a photovoltaic module including a cell string, an encapsulation layer, and a cover plate. The cell string is formed by connecting a plurality of solar cells as described in any one of the above embodiments. The encapsulation layer is used for covering a surface of the cell string. The cover plate is used for covering a surface of the encapsulation layer away from the cell string.

In the present application, providing the first passivation layer on the cutting surface can protect the cutting surface of the solar cell body from contaminants, and the first passivation layer can provide good passivation of the regions of the solar cell body that have been exposed on the cutting surface, which reduces the interface state density on the cutting surface, reduces the recombination of minority carriers, and enhances the lifetime of minority carriers, thereby reducing the recombination rate on the cutting surface. Meanwhile, the field passivation layer is disposed on one side of the first passivation layer facing away from the cutting surface, which further reduces the interface state density, and thus further improves the passivation effect on the cutting surface, and reduces the recombination efficiency on the cutting surface. Therefore, with the mutual cooperation of the first passivation layer and the field passivation layer, the solar cell of the present application can achieve better passivation of the regions of the substrate and the emitter of the solar cell body which have been exposed on the cutting surface simultaneously, to enhance the effect of repairing the cutting damage of the solar cell, and thus to enhance the efficiency of the solar cell and to enhance module power.

It should be understood that the above general description and the following detailed description are merely exemplary and cannot limit the present application.

### BRIEF DESCRIPTION OF DRAWINGS

To more clearly illustrate the technical solutions of the embodiments of the present application, the accompanying drawings required to be used in the embodiments will be introduced briefly in the following. Apparently, the accompanying drawings in the following description are only some embodiments of the present application, and those skilled in the art can also obtain other drawings according to these drawings without creative labor.
FIG. 1 is a cross-sectional structural schematic diagram of a solar cell provided by the present application in one specific embodiment;
FIG. 2 is a cross-sectional structural schematic diagram of a body of the solar cell provided by the present application;
FIG. 3 is a structural schematic diagram of a tandem solar cell provided by the present application in one specific embodiment;
FIG. 4 is a structural schematic diagram of a photovoltaic module provided by the present application in one specific embodiment.

Reference numerals:
100-solar cell;
10- solar cell body;
   1-substrate;
   2-emitter;
   3-second passivation layer;
   4-tunnel oxide layer;
   5-doped conductive layer;
   6-third passivation layer;
   7-first electrode;
   8-second electrode;
   9-cutting surface;
30-First passivation layer;
40-field passivation layer;
110-cell string;
120-encapsulation layer;
130-cover plate;
140- top solar cell;
150-intermediate connecting layer;
X-first direction;
Z-thickness direction.

The accompanying drawings here, which are incorporated in and constitute a part of the description, show the embodiments consistent with the present application and, together with the description, serve to explain the principles of the present application.

### DESCRIPTION OF EMBODIMENTS

To better understand the technical solutions of the present application, the embodiments of the present application are described in detail below in conjunction with the accompanying drawings.

In the description of this application, the terms "first" and "second" are used for descriptive purposes only and cannot be construed as indicating or implying relative importance; unless otherwise explicitly specified or indicated, the term "a plurality of" means two or more; and the terms "connection", "fixation" and the like are to be construed in a broad sense, for example, a "connection" may be a fixed connection, a detachable connection, or an integral connection, an electrical connection, a direct connection, or an indirect connection through an intermediary. For those of ordinary skill in the art, the specific meanings of the above terms in the present application can be understood according to the specific circumstances.

The terms used in the embodiments the present application are for the purpose of describing particular embodiments only and is not intended to limit the present application. As used in the embodiments of the present application and in the attached claims, the singular forms "a/an", "the", and "this" are intended to include plural form as well, unless the context clearly dictates otherwise.

It should be understood that the term "and/or" as used herein merely describes associations between associated objects, and it indicates three types of relationships, for example, A and/or B may indicate that A exists alone, A and B coexist, or B exists alone. In addition, the character "/" herein generally indicates that the associated objects are in an "or" relationship.

It should be noted that the directional words such as "above", "below", "left", "right" and the like described in the embodiments of the present application are described at the perspective shown in the accompanying drawings, and should not be understood as limiting the embodiments of the present application. Further, in this context, it should be understood that when referring to an element being connected "above" or "below" another element, the element can not only be directly connected "above" or "below" the another element, but the element can also be indirectly connected "above" or "below" the another element via an intermediate element.

Nowadays, many module technologies have emerged to improve the energy density of a photovoltaic module. Among them, module half-cut technology, stacked welding technology, and shingling technology are representative technologies. These technologies are characterized by cutting a whole solar cell wafer into one-half, one-third, or even smaller size of cutting cells, to form a half-cut solar cell or segmented solar cell, so as to add as many cutting cells as possible in a module, increasing effective power generation area; and at the same time, due to the reduction of the current in the cutting cells, causing a decrease in the loss of power and comprehensively improving the power of the module. In industrial applications, the way of dividing a solar cell wafer generally includes laser scribe and mechanical cleave, thermal laser low-damage cleave, etc., however it is prone to cause damage to the cutting cells in the process of dividing the solar cell wafer, thereby affecting the efficiency of the cutting cells.

In view of this, the present application provides a solar cell, a tandem solar cell, and a photovoltaic module, to reduce the recombination rate on a cutting surface and to improve the efficiency of a solar cell. The solar cell may be a tunnel oxide passivated contact (TOPCon) cell, and specifically may include a double-sided tunnel oxide passivated contact cell or a single-sided tunnel oxide passivated contact cell.

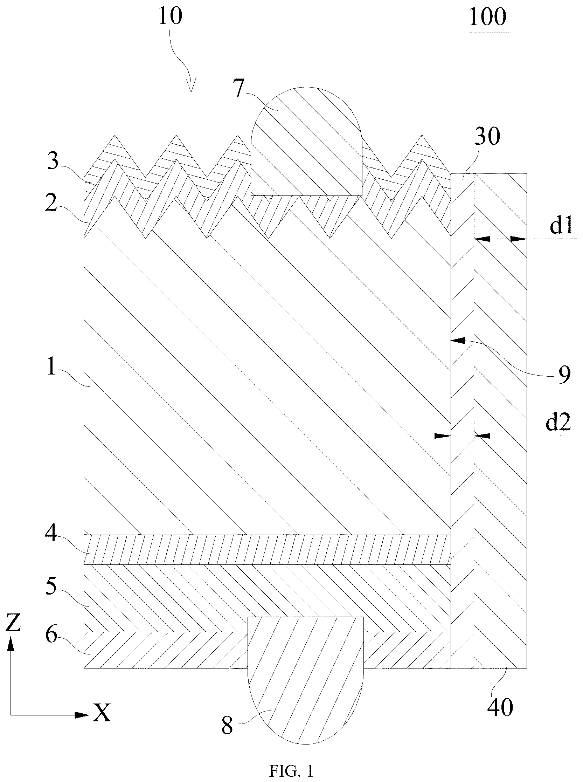

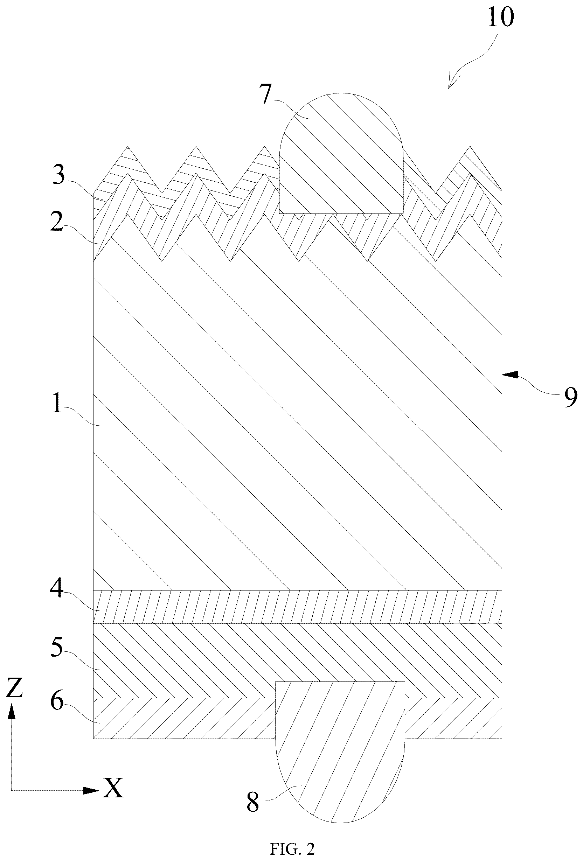

The structure of a solar cell 100 is shown in FIG. 1 and FIG. 2. In the process of preparing the solar cell 100, a prepared whole solar cell wafer can be cut into one-half, one-third, or even smaller sizes of cutting cells along a thickness direction Z. The cut solar cell piece is used as a cell body 10, as shown in FIG. 2. The cell body 10 has at least one cutting surface 9, and the cutting surface 9 is parallel to the thickness direction Z. A first passivation layer 30 and a field passivation layer 40 are sequentially provided on the cutting surface 9 of the cell body 10, thereby forming the solar cell 100 as shown in FIG. 1.

As shown in FIG. 2, the solar cell body 10 includes a substrate 1 and an emitter 2 formed on one side of the substrate 1 along the thickness direction Z of the solar cell 100.

As shown in FIG. 2, the substrate 1 of the solar cell body 10 is used for receiving incident light and generating photogenerated carriers. In some embodiments, the substrate 1 is a silicon substrate and may include one or more of monocrystalline silicon, polycrystalline silicon, amorphous silicon, or microcrystalline silicon. In other embodiments, the material of the substrate 1 may also be silicon carbide, an organic material, or a multicomponent compound. The multicomponent compound may include, but are not limited to, materials such as perovskite, gallium arsenide, cadmium telluride, copper indium selenide, and the like. Exemplarily, the substrate 1 in the present application is a monocrystalline silicon substrate. The substrate 1 has a doping element, the type of the doping element can be N-type or P-type. N-type element can be a Group V element, such as phosphorus (P) element, bismuth (Bi) element, antimony (Sb) element, or arsenic (As) element, and the like, and P-type element can be a III element such as boron (B) element, aluminum (Al) element, gallium (Ga) element or indium (In) element, and the like. For example, where the substrate 1 is a P-type silicon substrate, the type of the doping element in the substrate 1 is P-type. For another example, where the substrate 1 is an N-type silicon substrate, the type of the doping element in the substrate 1 is N-type. Exemplarily, the embodiments of the present application have the substrate 1 as an N-type silicon substrate to enhance the conversion efficiency of the solar cell 100 and reduce manufacturing cost. The emitter 2 and the substrate 1 have different types of doping elements, and the emitter 2 and the substrate 1 can form a PN junction structure together. Exemplarily, where the substrate 1 is an N-type silicon substrate, a P-type emitter 2 may be formed by performing boron diffusion on the substrate 1.

As shown in FIG. 2, the cutting surface 9 of the solar cell body 10 formed by cutting is parallel to the thickness direction Z. The cutting results in at least a portion of the emitter 2 and at least a portion of the substrate 1 of the solar cell body 10 being exposed on the cutting surface 9, thereby easily cause recombination of the region of the substrate 1 and the region of the PN junction.

As shown in FIG. 1, providing the first passivation layer 30 on the cutting surface 9 can protect the cutting surface 9 of the solar cell body 10 from contaminants, and the first passivation layer 30 can provide good passivation of the regions of the solar cell body 10 that have been exposed on the cutting surface 9, which reduces the interface state density on the cutting surface 9, reduces the recombination of minority carriers, and enhances the lifetime of minority carriers, thereby reducing the recombination rate on the cutting surface 9. Meanwhile, providing the field passivation layer 40 on one side of the first passivation layer 30 facing away from the cutting surface 9 further reduces the interface state density, thereby further enhancing the passivation effect on the cutting surface 9 and reducing the recombination efficiency on the cutting surface 9. Thus, with the mutual cooperation of the first passivation layer 30 and the field passivation layer 40, the solar cell 100 of the present application can achieve better passivation of the regions of the substrate 1 and the emitter 2 of the solar cell body 10 which have been exposed on the cutting surface 9 simultaneously, to enhance the effect of repairing the cutting damage of the solar cell 100, thereby enhancing the efficiency of the solar cell 100 and enhancing module power.

The number of the cutting surfaces 9 of the solar cell body 10 may be 1, 2, 3, 4, etc., depending on the difference in the region of the solar cell body 10 on the uncut whole solar cell wafer, without limitation herein.

It should be noted that the above-described first passivation layer 30 and field passivation layer 40 are all provided on the side of the solar cell body 10 having the cutting surface 9. That is to say, where the solar cell 10 body has a plurality of cutting surfaces 9, the first passivation layer 30 and the field passivation layer 40 are provided on the side layer of each of the cutting surfaces 9 of the solar cell body 10, to realize passivation of the exposed regions on the cutting surfaces 9, to improve the repair effect of the cutting damage to the solar cell 100, improve the efficiency of the solar cell 100, and improve module power.

In one or more embodiments, as shown in FIG. 1, the field passivation layer 40 and the emitter 2 have doping elements of different conductivity types.

In one or more embodiments, the field passivation layer 40 having a doping element of a different conductivity type than the emitter 2 is provided on one side of the first passivation layer 30 facing away from the cutting surface 9, which can further reduce the concentration of minority carriers in the emitter 2 on the cutting surface 9, further reduce the interface state density, and thus further improve the passivation effect on the cutting surface 9, and reduce the recombination efficiency on the cutting surface 9.

In one or more embodiments, as shown in FIG. 1, a doping concentration of the field passivation layer 40 is greater than a doping concentration of the substrate 1.

In one or more embodiments, the doping concentration of the field passivation layer 40 is greater than the doping concentration of the substrate 1, thereby enabling a doping concentration difference to be formed between the field passivation layer 40 and the substrate 1, thereby enabling a high-low junction to be formed between the field passivation layer 40 and the substrate 1, thereby enhancing the field passivation effect, and further enhancing the passivation effect of the field passivation layer 40 on the cutting surface 9.

In one or more specific embodiments, as shown in FIG. 1, the field passivation layer 40 is one or more of a doped polysilicon layer, a doped amorphous silicon layer, or a doped microcrystalline silicon layer.

In one or more embodiments, polysilicon, amorphous silicon, and microcrystalline silicon have the advantages of stable structure, easy preparation, and low cost, and are easy for doping of a doping element. Therefore, where the field passivation layer 40 is one or more of a doped polysilicon layer, a doped amorphous silicon layer, or a doped microcrystalline silicon layer, it is possible to facilitate the preparation of the field passivation layer 40, reduce the cost of preparation, and at the same time enhance the design freedom of the solar cell 100 and meet the design needs of the solar cell 100. In addition, where the field passivation layer 40 is one or more of a doped polysilicon layer, a doped amorphous silicon layer, or a doped microcrystalline silicon layer, the preparation efficiency of the field passivation layer 40 is higher than the preparation efficiency of the first passivation layer 30. Therefore, the first passivation layer 30 may be set lighter and thinner while ensuring the passivation effect thereof, but the field passivation layer is set thicker, so as to be able to ensure that the field passivation layer 40 and the first passivation layer 30 can coordinate with each other to enhance the passivation effect on the cutting surface 9 and at the same time, enhance the preparation efficiency.

In one or more specific embodiments, the field passivation layer 40 may be a single-layer structure. Specifically, the field passivation layer 40 may be one of a doped polycrystalline silicon layer, a doped amorphous silicon layer, or a doped microcrystalline silicon layer, which may be specifically set according to the actual needs, and is not limited herein.

In one or more specific embodiments, the field passivation layer 40 may also be a stacked-layer structure. Specifically, the field passivation layer 40 may also be more of a doped polycrystalline silicon layer, a doped amorphous silicon layer, or a doped microcrystalline silicon layer, which may be specifically set according to actual needs, and is not limited herein.

In one or more embodiments, as shown in FIG. 1, a thickness d1 of the field passivation layer 40 along a first direction X of the solar cell 100 satisfies: 10 nm ≤ d1 ≤ 100 nm; the first direction X is perpendicular to the thickness direction Z. For example, the thickness d1 of the field passivation layer 40 may be 10 nm, 20 nm, 30 nm, 40 nm, 50 nm, 60 nm, 70 nm, 80 nm, 90 nm, 100 nm, and the like. Of course, the thickness d1 of the field passivation layer 40 may also be other value within the above range, which is not limited herein.

In one or more embodiments, as shown in FIG. 1, if the thickness d1 of the field passivation layer 40 is too small, for example, d1 < 10 nm, the field passivation layer 40 is not able to effect field passivation and is prone to be worn out. If the thickness d1 of the field passivation layer 40 is too large, for example, d1 > 100 nm, the thickness of the first passivation layer 30 is too thick, which is prone to increase the overall volume of the solar cell 100, and also to increase preparation material and preparation cost.

Therefore, when the thickness d1 of the field passivation layer 40 satisfies 10 nm ≤ d1 ≤ 100 nm, the thickness of the field passivation layer 40 is moderate, the field passivation layer 40 has good wear-resistant properties, the field passivation layer 40 can better cooperate with the first passivation layer 30 to enhance the passivation effect on the cutting surface 9 and can avoid the volume of the solar cell 100 from being too large, and the preparation cost is lower, which is convenient for mass production.

In one specific embodiment, as shown in FIG. 1, the first passivation layer 30 is one or more of an aluminum oxide layer, a silicon oxide layer, a silicon nitride layer, or a silicon oxynitride layer.

Where, the first passivation layer 30 may be a single-layer structure of any one of an aluminum oxide layer, a silicon nitride layer, a silicon oxynitride layer, and a silicon oxide layer, which may be specifically set according to the actual needs, and is not limited herein. Exemplarily, the first passivation layer 30 is an aluminum oxide layer.

In one or more embodiments, the first passivation layer 30 may be a stacked-layer structure formed by a combination of more of an aluminum oxide layer, a silicon nitride layer, a silicon oxynitride layer, and a silicon oxide layer. Exemplarily, the first passivation layer 30 is a stacked-layer structure formed of an aluminum oxide layer and a silicon nitride layer, or the like. Of course, the first passivation layer 30 may also adopt other types of passivation layers, which is not limited herein.

In one or more embodiments, as shown in FIG. 1, the first passivation layer 30 includes at least an aluminum oxide layer.

In one or more embodiments, the aluminum oxide layer is self-negatively charged. Where the substrate 1 is an N-type silicon substrate and the emitter 2 is a P-type emitter, the minority carriers in the emitter 2 are negatively charged electrons. Therefore, the negative charges in the aluminum oxide layer can repel the minority carriers in the emitter 2, thereby being able to prevent the minority carriers in the emitter 2 from reaching the cutting surface 9 and being recombined, thereby reducing the recombination rate on the cutting surface 9, enhancing the passivation effect on the cutting surface 9, and enhancing the efficiency of the solar cell. The aluminum oxide can also promote the repair of defects on the silicon surface, which can enhance the repairing effect on the region of the emitter 2 and the region of the substrate 1 which have been exposed on the cutting surface 9 due to the damage generated by the cutting, and enhance the efficiency of the solar cell 100. The aluminum oxide can also serve to protect the solar cell body 10 from corrosion, while improving the stability and abrasion resistance of the cutting surface 9, extending the service life of the solar cell 100. Thus, where the first passivation layer 30 includes at least an aluminum oxide layer, better passivation and protection for the cutting surface 9 can be achieved, improving the efficiency of the solar cell 100 and extending the service life of the solar cell 100.

In one or more embodiments, as shown in FIG. 1, along a first direction X of the solar cell 100, a thickness d2 of the first passivation layer 30 satisfies: 1 nm ≤ d2 ≤ 4 nm. For example, the thickness d2 of the first passivation layer 30 may be 1 nm, 2 nm, 3 nm, 4 nm, etc., and of course, the thickness d2 of the first passivation layer 30 may be other value within the above range, which is not limited herein.

In one or more embodiments, as shown in FIG. 1, if the thickness d2 of the first passivation layer 30 is too small, for example, d2 < 1 nm, the passivation effect of the first passivation layer 30 is poor, and the preparation of the first passivation layer 30 is more difficult and not easy to realize. If the thickness d2 of the first passivation layer 30 is too large, for example, d2 > 4 nm, the thickness of the first passivation layer 30 is too large, which is prone to increase the overall volume of the solar cell 100, also is not conducive to realizing the field passivation effect by the field passivation layer 40, and will increase preparation time and reduce preparation efficiency.

Therefore, where the thickness d2 of the first passivation layer 30 satisfies 1 nm ≤ d2 ≤ 4 nm, the first passivation layer 30 has a moderate thickness, is easy to be prepared, has a good passivation effect, and is able to better cooperate with the field passivation layer 40 to achieve better passivation of the cutting surface 9.

In one specific embodiment, as shown in FIG. 2, the solar cell body 10 further includes a second passivation layer 3and a first electrode 7 along the thickness direction Z of the solar cell 100.

Where the second passivation layer 3 is provided on one side of the emitter 2 away from the substrate 1. The second passivation layer 3 can achieve good passivation on a surface of the one side of the emitter 2 away from the substrate 1, which reduces the interface state density, reduces the recombination of minority carriers, improves the transport efficiency of the carriers at the interface, and improves the efficiency of the solar cell 100. The second passivation layer 3 may also have the function of reducing or eliminating reflected light on the surface of the solar cell and increasing the amount of light transmission, further improving the photoelectric conversion efficiency of the solar cell. Exemplarily, the second passivation layer 3 may be deposited by using a plasma enhanced chemical vapor deposition method, and of course other methods may be used, for example, an organic chemical vapor deposition method, etc., to form the second passivation layer 3. Where the second passivation layer 3 may be a single-layer structure or a stacked-layer structure, and the refractive index and thickness of each layer may be designed correspondingly. Specifically, the second passivation layer 3 may be any one or a combination of more of a silicon nitride layer, a silicon oxynitride layer, and a silicon oxide layer. Of course, the second passivation layer 3 may also be other type of passivation layer, which is not limited herein.

The first electrode 7 is adapted to be electrically connected to the emitter 2. Exemplarily, the first electrode 7 may be prepared in a screen printing and sintering manner. In some embodiments, the metal paste for preparing the first electrode 7 may be one or more of aluminum, silver, gold, nickel, molybdenum, or copper, which is not limited herein.

In one or more embodiments, as shown in FIG. 2, the solar cell body 10 further includes a tunnel oxide layer 4, a doped conductive layer 5, a third passivation layer 6, and a second electrode 8 along the thickness direction Z of the solar cell 100.

In one or more embodiments, the tunnel oxide layer 4 is provided on one side of the substrate 1 away from the emitter 2. The tunnel oxide layer 4 mainly serves as a tunnel layer for the majority carriers, and at the same time is capable of chemically passivating the surface of the substrate 1 to reduce the interface state density, so as to allow the majority carriers to tunnel into the doped conductive layer 5, and at the same time can block the recombination of minority carriers. Exemplarily, the tunnel oxide layer 4 may be an ultrathin silicon oxide layer, the thickness of which may generally be between 1 nm and 2 nm, which may be specifically set according to the actual needs and is not limited herein. In some feasible embodiments, an ozone oxidation method, a high temperature thermal oxidation method, a nitric acid oxidation method, a chemical vapor deposition method, and a low-pressure chemical vapor deposition method may be used to form the tunnel oxide layer 4 on the one side of the substrate 1 facing away from the emitter 2.

The doped conductive layer 5 is provided on one side of the tunnel oxide layer 4 away from the substrate 1. The doped conductive layer 5 can be used as a field passivation layer, and the doped conductive layer 5 and the tunnel oxide layer 4 together form a passivation contact structure, which further enhances the passivation effect on the surface of the substrate 1. The doping element in the doped conductive layer 5 is the same as the doping element in the substrate 1 and forms a concentration difference with the doping element in the substrate 1, so that the doped conductive layer 5 can form a good contact with a metal electrode and can form an energy band bending on the surface of the substrate 1, realizing selective transport of carriers and reducing the loss of recombination. The doped conductive layer 5 can be formed by depositing on the surface of the tunnel oxide layer 4 by using any one of a physical vapor deposition method, a chemical vapor deposition method, a plasma enhanced chemical vapor deposition method, and an atomic layer deposition method.

The third passivation layer 6 is provided on one side of the doped conductive layer 5 away from the tunnel oxide layer 4. The third passivation layer 6 can achieve good passivation on a surface of the one side of the doped conductive layer 5 facing away from the substrate 1, which reduces the interface state density, reduces the recombination of minority carriers, improves the transport efficiency of the carriers at the interface, and improves the efficiency of the solar cell 100. Exemplarily, the third passivation layer 6 may be deposited by a plasma enhanced chemical vapor deposition method, and of course other methods, for example, an organic chemical vapor deposition method, may be used to form the third passivation layer 6. Where the third passivation layer 6 may be a single-layer structure or a stacked-layer structure, and the thickness of each layer may be designed correspondingly. Specifically, the third passivation layer 6 may be any one or a combination of more of a silicon nitride layer, a silicon oxynitride layer, a silicon oxide layer, and an aluminum oxide layer. Of course, the third passivation layer 6 may also be other type of passivation layer, which are not limited herein.

The second electrode 8 passes through the third passivation layer 6 to be electrically connected to the doped conductive layer 5. Exemplarily, the second electrode 8 may be prepared in a screen printing and sintering manner. In some embodiments, the metal paste for preparing the second electrode 8 may be one or more of aluminum, silver, gold, nickel, molybdenum, or copper, which is not limited herein.

It should be noted that during the preparation process of the above-described first passivation layer 30 and field passivation layer 40, at least a part of the first passivation layer 30 and the field passivation layer 40 may be positioned on the second passivation layer 3 and/or the third passivation layer 6, to further enhance preparation efficiency and reduce preparation difficulty, and the first passivation layer 30 and the field passivation layer 40 do not contact with the first electrode 7 and the second electrode 8, thereby reducing the detrimental effect of the degree of winding, enhancing the efficiency and production yield of the solar cell 100.

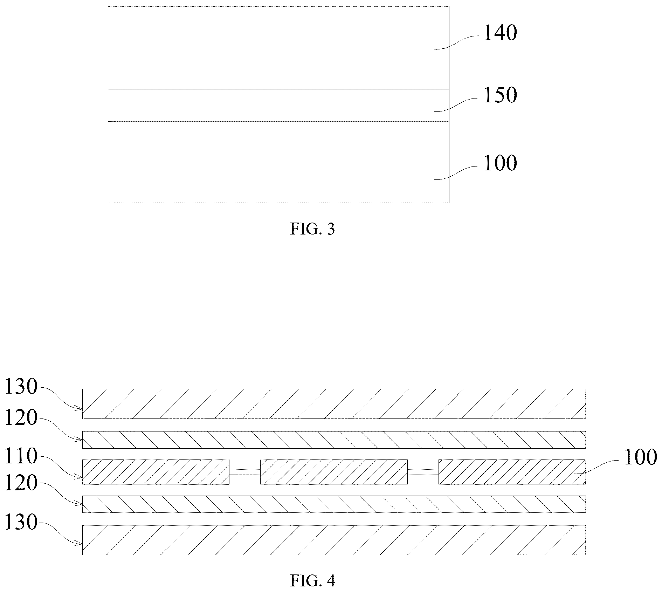

The present application further provides a tandem solar cell, as shown in FIG. 3, the tandem solar cell includes a bottom solar cell, a top solar cell 140, and an intermediate connecting layer 150. The bottom solar cell is a solar cell 100 in any of the above embodiments, the top solar cell 140 is one of a perovskite solar cell, a donor-acceptor cell, a cadmium telluride (CdTe) solar cell, a copper indium gallium selenide (CIGS) solar cell, or a gallium arsenide (GaAs) solar cell, and the intermediate connecting layer 150 is connected between the bottom solar cell and the top solar cell 140. Since the solar cell 100 has the above-described technical effects, the photovoltaic module including the solar cell 100 should also have the above-described technical effects, which will not be repeated herein.

In one or more embodiments, as shown in FIG. 3, the bandgap width of the top solar cell 140 is wider than the bandgap width of the bottom solar cell, and thus, stacking the top solar cell 140 above the bottom solar cell may make the tandem solar cell have a wider spectral response range, thereby maximizing the use of solar energy and improving the efficiency of the solar cell.

The intermediate connecting layer 150 is generally a tunnel junction or a very thin metal or transparent electrode composite layer. Exemplarily, the intermediate connecting layer 150 may be transparent conductive oxides (TCOs), which have good optoelectronic properties, high photon permeability and high electrical conductivity, thereby enabling the top solar cell 140 and the bottom solar cell to maintain good ohmic contact.

The present application further provides a photovoltaic module, as shown in FIG. 4, the photovoltaic module includes a cell string 110, an encapsulation layer 120, and a cover plate 130. The cell string 110 is formed by connecting a plurality of solar cells 100 in any one of the above embodiments, the encapsulation layer 120 is used for cover a surface of the cell string 110, and the cover plate 130 is used for covering a surface of the encapsulation layer 120 away from the cell string 110. Since the solar cell 100 has the above-described technical effects, the photovoltaic module including the solar cells 100 should also have the above-described technical effects, which will not be repeated herein.

In one or more embodiments, as shown in FIG. 4, the solar cells 100 are electrically connected in the form of a whole wafer or a plurality of separate wafers to form the plurality of cell strings 110, and the plurality of cell strings 110 are electrically connected in series and/or in parallel. Specifically, the plurality of cell strings 110 may be electrically connected to each other by conductive tapes. The encapsulation layer 120 covers the front side and the back side of the solar cells, and specifically, the encapsulation layer 120 may be an organic encapsulation film, such as an ethylene vinyl acetate copolymer (EVA) film, a polyethylene octene co-elastomer (POE) film, a polyethylene glycol terephthalate (PET) film, or a polyvinyl butyral (PVB) film, etc. The cover plate 130 may be a cover plate 130 with a light transmittance function, such as a glass cover plate, a plastic cover plate, etc. Specifically, a surface of the cover plate 130 toward the encapsulation layer 120 may be a concave-convex surface so as to increase the utilization rate of the incident light.

The same or similar parts between the various embodiments in this specification can be referred to each other. In particular, for the device embodiments and the terminal embodiments, since they are basically similar to the method embodiments, the description thereof is relatively simple, and the relevant parts can be referred to the description in the method embodiments.

The invention is also directed to the following embodiments:
1. A solar cell, comprising:
   a solar cell body (10), wherein the solar cell body (10) comprises a substrate (1) and an emitter (2) formed on a side of the substrate (1) along a thickness direction (Z) of the solar cell (100), and the solar cell body (10) comprises at least one cutting surface (9) parallel to the thickness direction (Z);
   a first passivation layer (30), disposed on the cutting surface (9); and
   a field passivation layer (40), disposed on one side of the first passivation layer (30) facing away from the substrate (1).
2. The solar cell according to embodiment 1, wherein the field passivation layer (40) comprises a doping element with a conductivity type different from a conductivity type of a doping element of the emitter (2).
3. The solar cell according to embodiment 1 or 2, wherein a doping concentration of the field passivation layer (40) is greater than a doping concentration of the substrate (1).
4. The solar cell according to any one of embodiments 1 to 3, wherein the field passivation layer (40) is one or more of a doped polycrystalline silicon layer, a doped amorphous silicon layer or a doped microcrystalline silicon layer.
5. The solar cell according to any one of embodiments 1-4, wherein along a first direction (X) of the solar cell (100), a thickness d1 of the field passivation layer (40) satisfies: 10 nm ≤ d1 ≤ 100 nm; and
   the first direction (X) is perpendicular to the thickness direction (Z).
6. The solar cell according to embodiment 5, wherein the thickness d1 of the field passivation layer (40) satisfies: 20 nm ≤ d1 ≤ 90 nm.
7. The solar cell according to any one of embodiments 1-4, wherein the first passivation layer (30) is one or more of an aluminum oxide layer, a silicon oxide layer, a silicon nitride layer or a silicon oxynitride layer.
8. The solar cell according to embodiment 7, wherein the first passivation layer (30) comprises at least an alumina layer.
9. The solar cell according to any one of embodiments 1-4, wherein along a first direction (X) of the solar cell (100), a thickness d2 of the first passivation layer (30) satisfies: 1 nm ≤ d2 ≤ 4 nm.
10. The solar cell according to embodiment 9, wherein, the thickness d2 of the first passivation layer (30) satisfies: 2 nm ≤ d2 ≤ 3 nm.
11. The solar cell according to any one of embodiments 1-4, further comprising a second passivation layer (3) and a first electrode (7) along the thickness direction (Z) of the solar cell (100); wherein
   the second passivation layer (3) is disposed on a side of the emitter (2) away from the substrate (1); and
   the first electrode (7) is adapted to (3) to be electrically connected to the emitter (2).
12. The solar cell according to embodiment 11, the second passivation layer (3) is any one or a combination of more of a silicon nitride layer, a silicon oxynitride layer, and a silicon oxide layer.
13. The solar cell according to any one of embodiments 1-4, further comprising: along the thickness direction (Z) of the solar cell (100),
   a tunnel oxide layer (4) disposed on one side of the substrate (1) away from the emitter (2);
   a doped conductive layer (5) disposed on one side of the tunnel oxide layer (4) away from the substrate (1);
   a third passivation layer (6) disposed on one side of the doped conductive layer (5) away from the tunnel oxide layer (4); and
   a second electrode (8) passing through the third passivation layer (6) to be electrically connected to the doped conductive layer (5).
14. A tandem solar cell, comprising:
   a bottom solar cell, wherein the bottom solar cell is the solar cell (100) according to any one of embodiments 1-13;
   a top solar cell (140), wherein the top solar cell (140) is one of a perovskite solar cell, a donor-acceptor solar cell, a cadmium telluride solar cell, a copper indium gallium selenide solar cell, or a gallium arsenide solar cell; and
   an intermediate connecting layer (150), wherein the intermediate connecting layer (150) is connected between the bottom solar cell and the top solar cell (140).
15. A photovoltaic module, comprising:
   at least one cell string (110) formed by connecting a plurality of solar cells (100) according to any one of embodiments 1-13;
   an encapsulation layer (120) adapted for covering a surface of the cell string (110); and
   a cover plate (130) adapted for covering a surface of the encapsulation layer (120) away from the cell string (110).

## Claims

1. A solar cell, comprising:
a substrate (1);
at least one cutting surface (9);
a first passivation layer (30), disposed on the cutting surface (9);
a field passivation layer (40), disposed on one side of the first passivation layer (30) facing away from the substrate (1); and
wherein the first passivation layer (30) is one or more of an aluminum oxide layer, a silicon oxide layer, a silicon nitride layer or a silicon oxynitride layer;
wherein the field passivation layer (40) is one or more of a doped polycrystalline silicon layer, a doped amorphous silicon layer or a doped microcrystalline silicon layer.

2. The solar cell according to claim 1, wherein a doping concentration of the field passivation layer (40) is greater than a doping concentration of the substrate (1).

3. The solar cell according to claim 1, wherein along a first direction (X) of the solar cell (100),
a thickness d1 of the field passivation layer (40) satisfies: 10 nm ≤ d1 ≤ 100 nm; and
the first direction (X) is perpendicular to the thickness direction (Z).

4. The solar cell according to claim 1, wherein the thickness d1 of the field passivation layer (40) satisfies: 20 nm ≤ d1 ≤ 90 nm.

5. The solar cell according to claim 1, wherein the first passivation layer (30) comprises at least an alumina layer.

6. The solar cell according to claim 1, wherein the first passivation layer (30) comprises at least a silicon oxide layer.

7. The solar cell according to any one of claims 1-6, wherein along a first direction (X) of the solar cell (100), a thickness d2 of the first passivation layer (30) satisfies: 1 nm ≤ d2 ≤ 4 nm.

8. The solar cell according to claim 7, wherein, the thickness d2 of the first passivation layer (30) satisfies: 2 nm ≤ d2 ≤ 3 nm.

9. The solar cell according to claim 1, further comprising a second passivation layer (3) and a first electrode (7) along the thickness direction (Z) of the solar cell (100); wherein
the second passivation layer (3) is disposed on a side of the emitter (2) away from the substrate (1); and the first electrode (7) is adapted to (3) to be electrically connected to the emitter (2).

10. The solar cell according to claim 9, the second passivation layer (3) is any one or a combination of more of a silicon nitride layer, a silicon oxynitride layer, and a silicon oxide layer.

11. The solar cell according to claim 1, further comprising: along the thickness direction (Z) of the solar cell (100),
a tunnel oxide layer (4) disposed on one side of the substrate (1) away from the emitter (2);
a doped conductive layer (5) disposed on one side of the tunnel oxide layer (4) away from the substrate (1);
a third passivation layer (6) disposed on one side of the doped conductive layer (5) away from the tunnel oxide layer (4); and
a second electrode (8) passing through the third passivation layer (6) to be electrically connected to the doped conductive layer (5).

12. The solar cell according to claim 11, wherein the third passivation layer (6) is any one or a combination of more of a silicon nitride layer, a silicon oxynitride layer, a silicon oxide layer, and an aluminum oxide layer.

13. The solar cell according to claim 12, wherein at least part of the first passivation layer and at least part of the field passivation layer are positioned on a second passivation layer and/or a third passivation layer.

14. A tandem solar cell, comprising:
a bottom solar cell, wherein the bottom solar cell is the solar cell (100) as claimed in any one of claims 1-13;
a top solar cell (140), wherein the top solar cell (140) is one of a perovskite solar cell, a donor-acceptor solar cell, a cadmium telluride solar cell, a copper indium gallium selenide solar cell, or a gallium arsenide solar cell; and
an intermediate connecting layer (150), wherein the intermediate connecting layer (150) is connected between the bottom solar cell and the top solar cell (140).

15. A photovoltaic module, comprising:
at least one cell string (110) formed by connecting a plurality of solar cells (100) as claimed in any one of claims 1-13 or a tandem solar cell as claimed in claim 14;
an encapsulation layer (120) adapted for covering a surface of the cell string (110); and
a cover plate (130) adapted for covering a surface of the encapsulation layer (120) away from the cell string (110).
